Europäisches Patentamt

European Patent Office

Office européen des brevets

(11) Veröffentlichungsnummer: **0 133 991**
A2

(12) # EUROPÄISCHE PATENTANMELDUNG

(21) Anmeldenummer: **84109119.2**

(51) Int. Cl.⁴: **H 03 G 3/20**

(22) Anmeldetag: **01.08.84**

(30) Priorität: **04.08.83 DE 3328254**

(43) Veröffentlichungstag der Anmeldung: **13.03.85**
**Patentblatt 85/11**

(84) Benannte Vertragsstaaten: **AT BE CH DE FR GB IT LI NL SE**

(71) Anmelder: **Siemens Aktiengesellschaft, Berlin und München Wittelsbacherplatz 2, D-8000 München 2 (DE)**

(72) Erfinder: **Haass, Adolf, Ing. grad., Eichelhäherstrasse 54, D-8000 München 60 (DE)**

(54) **Schaltungsanordnung zum Verstärken bzw. Dämpfen von analogen Eingangssignalen.**

(57) Bei einer Schaltungsanordnung zum Verstärken bzw. Dämpfen von analogen Eingangssignalen werden die analogen Eingangssignale zunächst in einer analogen Verstärkungs- bzw. Dämpfungsanordnung (AS) in einen bestimmten Pegelbereich gebracht, und das in ein digitales Signal umgesetzte jeweilige Ausgangssignal der analogen Verstärkungs- bzw. Dämpfungsanordnung (AS) wird dann im Wert in festgelegten Stufen in einem digitalen Schaltungsteil (DS) verändert.

SIEMENS AKTIENGESELLSCHAFT          Unser Zeichen
Berlin und München                  VPA 83 P 1 5 4 3 E

### Schaltungsanordnung zum Verstärken bzw. Dämpfen von analogen Eingangssignalen

Die Erfindung bezieht sich auf eine Schaltungsanordnung zum Verstärken bzw. Dämpfen von analogen Eingangssignalen mit einer Verstärkungs- bzw. Dämpfungsanordnung.

Es ist bereits eine Schaltungsanordnung zum Einstellen der Verstärkung eines Verstärkers mit Hilfe von digitalen Steuersignalen bekannt (DE-AS 27 22 311), bei der für die Verstärkungseinstellung ein im Dualcode auftretendes Steuersignal verwendet wird, mit dessen Hilfe Schalterkontakte gesteuert werden. Dabei sind die im Rückkopplungskreis des Verstärkers liegenden Widerstände jeweils einem normalerweise vorhandenen Rückkopplungswiderstand parallel schaltbar. Um dabei eine feine Stufung der Verstärkungseinstellung zu erzielen, ist insgesamt ein relativ hoher schaltungstechnischer Aufwand hinsichtlich analog arbeitender Schaltungseinrichtungen erforderlich.

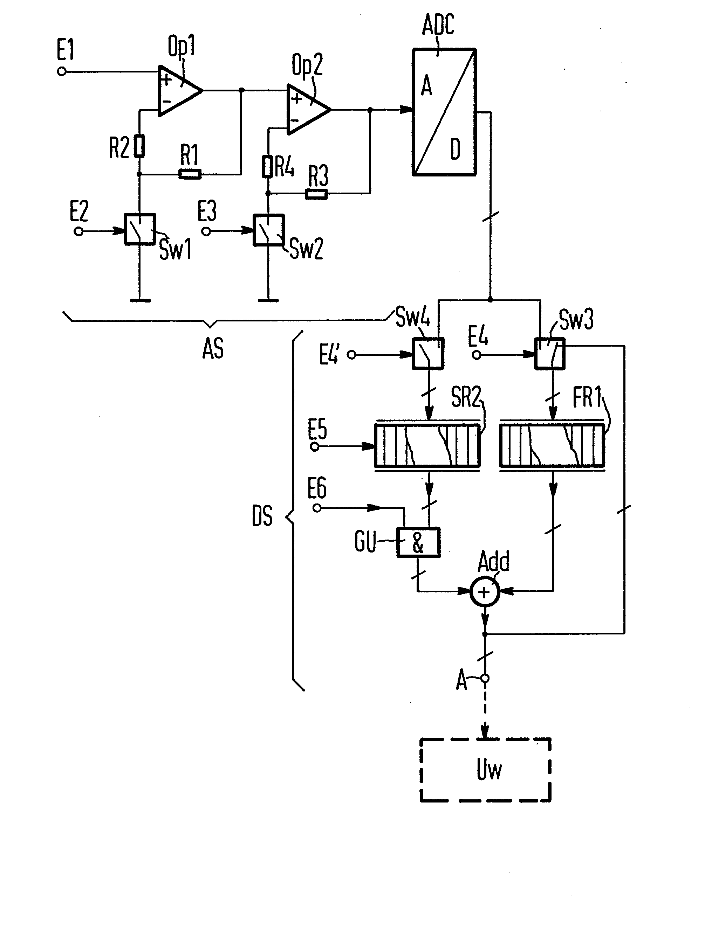

Es ist ferner eine Schaltungsanordnung zum Einstellen einer T-förmigen Widerstandsanordnung bekannt, die aus Längswiderständen und Querwiderständen besteht und mit der Umschalter verbunden sind, die durch digitale Steuersignale steuerbar sind (Zeitschrift "Elektronik" 1976, Heft 1, Seite 78, insbesondere Bild 7). Die bei dieser bekannten Schaltungsanordnung vorgesehene T-förmige Widerstandsanordnung stellt ein sogenanntes R-2R-Netzwerk

Nt 1 Kom / 03.08.1983

0133991

dar, welches zu einem Digital-Analog-Umsetzer gehört. Um mit Hilfe dieser bekannten Schaltungsanordnung eine feingestufte Einstellung eines Dämpfungsgrades durch entsprechend wirksam bzw. unwirksam geschaltete Widerstände zu erzielen, ist auch hier ein relativ hoher schaltungstechnischer Aufwand erforderlich.

Der Erfindung liegt nun die Aufgabe zugrunde, einen Weg zu zeigen, wie bei einer Schaltungsanordnung der eingangs genannten Art mit geringerem schaltungstechnischen Aufwand ausgekommen werden kann, um eine feingestufte Einstellung des Verstärkungsgrades einer Verstärkungsanordnung bzw. des Dämpfungsgrades einer Dämpfungsanordnung zu erzielen.

Gelöst wird die vorstehend aufgezeigte Aufgabe bei einer Schaltungsanordnung der eingangs genannten Art erfindungsgemäß dadurch, daß das als analoges Signal vorhandene Eingangssignal zunächst in einer analogen Verstärkungs- bzw. Dämpfungsanordnung in einen bestimmten Pegelbereich gebracht wird, daß das Ausgangssignal der analogen Verstärkungs- bzw. Dämpfungsanordnung in ein digitales Signal umgesetzt wird und daß der Wert des digitalen Signals in festgelegten Stufen verändert wird.

Die Erfindung bringt den Vorteil mit sich, daß insgesamt mit einem relativ geringen schaltungstechnischen Aufwand ausgekommen werden kann, um den Verstärkungsgrad der Verstärkungsanordnung bzw. den Dämpfungsgrad der Dämpfungsanordnung in gewünschter Weise einstellen zu können. Durch die zunächst als Vorverarbeitung erfolgende Verarbeitung des analogen Eingangssignales ist es nämlich möglich, bei der anschließend erfolgenden Analog-Digital-Umsetzung und der sodann sich anschließenden digitalen Verarbeitung des betreffenden Signales

0133991

mit einer geringeren Anzahl von Signalelementen auszukommen, als dies der Fall wäre, wenn von vornherein das
Eingangssignal sofort in ein digitales Signal umgesetzt
und lediglich als digitales Signal verarbeitet würde.

Zweckmäßigerweise enthält die Verstärkungs- bzw. Dämpfungsanordnung eine erste Verstärkungs- bzw. Dämpfungsstufe, von der das analoge Ausgangssignal in seiner
Amplitude entweder unverändert oder entsprechend einem
Faktor von 2 verändert abgebbar ist. Dies bringt den
Vorteil eines besonders einfachen Schaltungsaufbaues in
der Schaltungsanordnung gemäß der Erfindung mit sich.

Zweckmäßigerweise ist der genannten ersten Verstärkungs-
bzw. Dämpfungsstufe wenigstens eine weitere Verstärkungs- bzw. Dämpfungsstufe nachgeschaltet, von deren
jeder das analoge Ausgangssignal der jeweils vorangehenden Verstärkungs- bzw. Dämpfungsstufe in seiner Amplitude unverändert oder entsprechend einem Faktor $v_x$ verändert abgebbar ist, der der Beziehung

$$v_x = (v_{x-1})^2$$

genügt, wobei $v_{x-1}$ der Verstärkungs- bzw. Dämpfungsgrad
der der jeweiligen weiteren Verstärkungs- bzw. Dämpfungsstufe unmittelbar vorangehenden Verstärkungs- bzw.
Dämpfungsstufe bedeutet. Hierdurch ergibt sich der Vorteil, daß auf relativ einfache Weise eine gewünschte
Stufung des Verstärkungs- bzw. Dämpfungsgrades im analogen Schaltungsteil der Schaltungsanordnung gemäß der
Erfindung erreichbar ist.

Im digitalen Schaltungsteil erfolgt die Veränderung des
Wertes des digitalen Signales vorzugsweise mittels einer
Registeranordnung, in der das jeweilige digitale Signal
entsprechend einer geforderten Vergrößerung bzw. Wertverkleinerung  verschiebbar ist. Dies bringt den Vorteil

0133991

eines besonders geringen schaltungstechnischen Aufwands in dem digitalen Schaltungsteil der Schaltungsanordnung gemäß der Erfindung mit sich.

Vorzugsweise enthält die zuvor erwähnte Registeranordnung ein Festregister, in dem das digitale Signal festgehalten wird und das über eine Addier- bzw. Subtrahiereinrichtung mit einem Schieberegister verbunden ist, in welchem das dort ebenfalls eingeschriebene digitale Signal durch Verschieben in seinem Wert veränderbar ist. Hierdurch ergibt sich der Vorteil einer insgesamt relativ einfach aufzubauenden Registeranordnung für den genannten digitalen Schaltungsteil.

Anhand einer Zeichnung wird die Erfindung nachstehend beispielsweise näher erläutert.

In der Zeichnung ist in einem Blockschaltbild eine Schaltungsanordnung mit veränderbarem Verstärkungsgrad dargestellt. Die betreffende Schaltungsanordnung umfaßt einen analogen Schaltungsteil AS und einen diesem nachgeordneten digitalen Schaltungsteil DS.

Der analoge Schaltungsteil AS weist im vorliegenden Fall zwei Verstärkungsstufen auf, deren eine einen Operationsverstärker Op1 und deren andere einen Operationsverstärker Op2 umfaßt. Der Operationsverstärker Op1 ist mit seinem nichtinvertierenden Eingang + an einem Eingangsanschluß E1 angeschlossen, dem ein Eingangssignal zugeführt wird, welches gegebenenfalls in seiner Amplitude verändert wird. Über einen Rückkopplungswiderstand R1 ist der Ausgang des Operationsverstärkers Op1 mit dessen invertierendem Eingang - verbunden. Dieser Schaltungspunkt liegt über einen Widerstand R2 und einen Schalter/Sw1 an Masse. Der Betätigungseingang des Schalters Sw1 ist mit einem Steuereingang E2 verbunden.

In der anderen Verstärkungsstufe ist der Operationsverstärker Op2 mit seinem nichtinvertierenden Eingang + am Ausgang der ersten Verstärkungsstufe und damit am Ausgang des Operationsverstärkers Op1 angeschlossen. Über einen Rückkopplungswiderstand R3 ist der Ausgang des Operationsverstärkers Op2 mit dessen invertierenden Eingang - verbunden. Dieser Schaltungspunkt liegt über einen Widerstand R4 und einen Schalter Sw2 an Masse. Der Steuer- bzw. Betätigungseingang des Schalters Sw2 ist mit einem Steuereingang E3 verbunden.

Der digitale Schaltungsteil DS umfaßt eine Registeranordnung, zu der ein Festregister FR1 und ein Schieberegister SR2 gehören. Das Festregister FR1 erhält eingangsseitig digitale Signale über einen Umschalter Sw3 zugeführt, der von einem Steuereingang E4 her betätigbar ist. Derartige digitale Signale werden auch der Eingangsseite des Schiebereigsters SR2 über einen Schalter SR4 zugeführt, dem von einem Steuereingang E4' her Steuer- bzw. Betätigungssignale zuführbar sind. Die beiden Steuereingänge E4 und E4' können ggf. miteinander verbunden sein.

Mit seinem Ausgang ist das Festregister FR1 mit dem einen Eingang eines Addierers Add verbunden, der eingangsseitig ferner über ein UND-Glied GU an der Ausgangsseite des Schieberegisters SR2 angeschlossen ist. Der Ausgang des Addierers Add ist über den erwähnten Umschalter Sw3 mit der Eingangsseite des Festregisters FR1 verbunden. Außerdem ist der Ausgang des Addierers Add mit einem Ausgangsanschluß A verbunden, von dem das jeweilige Ausgangssignal des Addierers Add abgegeben wird. An dieser Stelle sei angemerkt, daß die in der Zeichnung jeweils durch einen Querstrich markierten Leitungen die Bedeutung haben, daß sie jeweils durch eine Mehrzahl von Einzelleitungen gebildet sind, auf/denen

parallel die ditigalen Signale bildende Signalelemente auftreten, bei denen es sich im vorliegenden Fall um Binärsignalelemente handeln mag.

Das vorstehend erwähnte Schieberegister SR2 ist eingangsseitig mit einem Steuereingang E5 verbunden; das UND-Glied GU ist eingangsseitig mit einem Steuereingang E6 verbunden. Auf die Bedeutung dieser Steuereingänge sowie auf die Bedeutung der übrigen Steuereingänge wird nachstehend noch näher eingegangen werden.

Die der vorstehend erwähnten Registeranordnung zuzuführenden digitalen Signale werden von einem Analog-Digital-Wandler ADC bereitgestellt, der zwischen der Ausgangsseite des analogen Schaltungsteiles AS und der Eingangsseite des digitalen Schaltungsteiles DS vorgesehen ist, bzw. der einem dieser Schaltungsteile zugehörig sein mag. Dieser Analog-Digital-Wandler ADC setzt die ihm von dem analogen Schaltungsteil AS jeweils zugeführten analogen Signale in entsprechende digitale Signale um.

Nachdem zuvor der Aufbau der in der Zeichnung dargestellten Schaltungsanordnung erläutert worden ist, sei nunmehr die Arbeitsweise dieser Schaltungsanordnung näher betrachtet. Zuvor seien jedoch noch einige Ausführungen zu dem analogen Schaltungsteil AS und zu dem digitalen Schaltungsteil DS gegeben.

Die in der Zeichnung dargestellten beiden Verstärkungsstufen des analogen Schaltungsteiles AS sollen so bemessen sein, daß je nach Schalterstellung des jeweiligen Schalters SW1 bzw. Sw2 ein dem nichtinvertierenden Eingang + des jeweiligen Operationsverstärkers Op1 bzw. Op2 zugeführtes analoges Eingangssignal in seiner Amplitude entweder unverändert oder aber verändert weitergegeben wird. Die den Operationsverstärker Op1 umfassende

0133991

Verstärkungsstufe sei dabei so bemessen, daß sie in Abhängigkeit von der Schalterstellung des Schalters Sw1 einen Verstärkungsfaktor von 1 oder von 2 hat. Die den Operationsverstärker Op2 umfassende Verstärkungsstufe mag so ausgelegt sein, daß sie in Abhängigkeit von der Schalterstellung des Schalters Sw2 einen Verstärkungsfaktor von 1 oder von 4 hat. An dieser Stelle sei angemerkt, daß ggf. noch weitere Verstärkungsstufen der den Operationsverstärker Op2 umfassenden Verstärkungsstufe nachgeschaltet sein können, die alle in gleicher Weise aufgebaut sein können, wie dies in der Zeichnung gezeigt ist. Betrachtet man die den Operationsverstärker Op1 umfassende Verstärkungsstufe als erste Verstärkungsstufe in einer solchen Reihe von Verstärkungsstufen, so ist jede weitere Verstärkungsstufe so bemessen, daß das von der jeweils vorangehenden Verstärkungsstufe abgegebene analoge Signal entweder unverändert oder entsprechend eimem Verstärkungsfaktor $v_x$ verändert abgegeben wird, der der Beziehung

$$v_x = (v_{x-1})^2$$

genügt, wobei $v_{x-1}$ der Verstärkungsfaktor bzw. Verstärkungsgrad der der jeweiligen weiteren Verstärkungsstufe unmittelbar vorangehenden Verstärkungsstufe bedeutet. Demgemäß wäre eine der Verstärkungsstufe mit dem Operationsverstärker Op2 unmittelbar nachgeschaltete Verstärkungsstufe so ausgelegt, daß sie entsprechend der Schalterstellung ihres Schalters einen Verstärkungsfaktor von 1 oder 16 hätte.

Das Schieberegister SR2 des in der Zeichnung dargestellten digitalen Schaltungsteiles DS soll so ausgelegt bzw. betreibbar sein, daß es ein in ihm enthaltenes digitales Signal auf die Zuführung entsprechender Steuersignale am Steuereingang E5 hin im vorliegenden Fall um jeweils eine Schieberegisterstufe nach rechts, d.h. zu den niedrigen Bitstellen hin zu verschieben gestattet. Dies kommt einer Teilung des Wertes des im Schieberegister SR2 jeweils enthaltenen digitalen Signals um den Faktor 2 gleich.

Geht man nun davon aus, daß dem Eingangsanschluß E1 ein analoges Eingangssignal mit einer Amplitude U zugeführt wird, so gibt der analoge Schaltungsteil AS ausgangsseitig ein analoges Ausgangssignal ab, welches in Abhängigkeit von der Einstellung der Schalter Sw1, Sw2 folgende Amplituden aufweisen kann: U, 2U, 4U oder 8U.

Das von dem analogen Schaltungsteil AS jeweils abgegebene analoge Ausgangssignal wird nach Umsetzung in dem Analog-Digital-Wandler ADC als digitales Signal dem digitalen Schaltungsteil DS zur Verfügung gestellt, wobei das betreffende digitale Signal über die entsprechend eingestellten Schalter Sw3, Sw4 in das Festregister FR1 und in das Schieberegister SR2 eingespeichert wird. Dieses digitale Signal sei zunächst mit X bezeichnet.

Nimmt man nun noch an, daß das UND-Glied GU zunächst nicht übertragungsfähig ist, so gibt das Festregister FR1 ausgangsseitig das digitale Signal X über den Addierer Add an den Ausgangsanschluß A ab, mit dem - wie dies durch gestrichelte Linien angedeutet ist - eine Auswerte- bzw. Überwachungseinrichtung Uw bzw. eine Verstärkungsregelanordnung mit einem Einstelleingang verbunden sein mag, über den der Verstärkungsfaktor bzw. der Verstärkungsgrad der Verstärkungsanordnung AS, DS überwacht bzw. ggf. eingestellt wird.

Wenn nun dem Steuereingang E5 des Schieberegisters SR2 ein Steuersignal in Form eines Schiebesignals zugeführt wird, so mag das in diesem Schieberegister SR2 enthaltene digitale Signal X um eine Bitstelle nach rechts zu

0133991

den niedrigen Bitstellen hin verschoben werden. Damit ist rein wertmäßig das digitale Signal X in dem Schieberegister SR2 zu einem digitalen Signal X/2 geworden. Wenn nun dem Steuereingang E6 ein "1"-Signal zugeführt wird, so daß das UND-Glied GU in den übertragungsfähigen Zustand gelangt, wird dieses digitale Signal X/2 zu dem digitalen Signal X von dem Festregister FR1 addiert. Der Addierer gibt damit ein digitales Ausgangssignal entsprechend der Summe von X+X/2 ab. Dieses digitale Ausgangssignal wird im übrigen über den nunmehr wieder in seiner aus der Zeichnung ersichtlichen Stellung befindlichen Schalter Sw3 dem Festregisker FR1 zugeführt und in diesem anstelle des bisher dort enthaltenen digitalen Signals X gespeichert. Wenn daraufhin dem Steuereingang E5 wieder ein entsprechendes Steuersignal zugeführt wird, so daß der Inhalt des Schieberegisters SR2 wieder um eine Bitstelle zu den niedrigen Bitstellen hin verschoben wird, so ist in diesem Schieberegister danach das digitale Signal im Wert X/4 enthalten. Wird das UND-Glied GU wieder übertragungsfähig gemacht, so wird zu dem im Register FR1 enthaltenen digitalen Signal mit dem Wert X+X/2 noch der Wert X/4 hinzuaddiert. Dieser Vorgang kann beliebig oft - je nach Genauigkeitsansprüchen - wiederholt werden. Das so gebildete digitale Signal wird dann dem Ausgangsanschluß A zugeführt.

Den vorstehend im Zusammenhang mit dem digitalen Schaltungsteil DS erläuterten Vorgängen entsprechende Vorgänge führen dazu, daß dem ursprünglich zugeführten digitalen Signal mit dem Wert X fortlaufend entsprechend einer binären Untersetzung kleiner werdende Signalanteile X/2, X/4, X/8, X/16... wahlweise hinzuaddiert werden. Damit ergibt sich folgender Regelbereich: als minimale Ausgangsgröße wird die Größe X abgegeben und als maximale Ausgangsgröße wird die Größe X+X/2+X/4+..., d.h. etwa 2X abgegeben, so daß die von dem analogen Schaltungsteil AS her jeweils abgegebenen Signale in der Amplitude entsprechend einem Amplitudenbereich mit den Faktoren 1 bis 2 abgegeben werden können. Dabei hat sich gezeigt, daß durch diese digitale Verarbeitung erreicht wird, daß mit nur zwei analogen Schaltstufen ausgekommen werden kann, um die gleiche Stufung in dem schließlich abgegebenen (geregelten) Ausgangssignal zu erzielen, wie sie sonst mittels einer zehn Bit umfassenden analogen Einstellung erreichbar wäre.

Bezüglich der Überwachungseinrichtung Uw sei noch kurz folgendes angemerkt. Dieser Überwachungseinrichtung Uw, die eine Verstärkungsregelungseinrichtung sein kann, mit deren Hilfe der Verstärkungsgrad der erläuterten Schaltungsanordnung überwacht und ggf. eingestellt wird, werden die vom Ausgang des Addierers Add abgegebenen digitalen Signale zugeführt, um beispielsweise mit vorgegebenen digitalen Signalen verglichen zu werden. Zu diesem Zweck kann in der Überwachungseinrichtung Uw ein Zähler von dem von dem Addierer Add jeweils abgegebenen digitalen Signal eingestellt werden, wobei die Zählerstellung dieses Zählers mittels einer Vergleicheranordnung mit einem fest vorgegebenen digitalen Signal verglichen wird. Die Vergleicheranordnung kann dabei die Abgabe von Steuersignalen bewirken, die der obenbeschriebenen Schaltungsanordnung zuzuführen sind. Diese Abgabe von Steuersignalen kann dabei solange erfolgen, bis der gewünschte Verstärkungsgrad in der betrachteten Schaltungsanordnung erreicht ist.

Abschließend sei noch angemerkt, daß in Abweichung von den vorstehend erläuterten Verhältnissen auch so vorgegangen werden könnte, daß im analogen Schaltungsteil AS die Amplitude des dem Eingangsanschluß E1 jeweils zugeführten analogen Einstellsignals stufenweise herabgesetzt wird. Im übrigen könnte der digitale Schaltungsteil DS auch so ausgeführt sein, daß das in dem Schieberegister SR2 jeweils enthaltene digitale Signal von dem digitalen Signal subtrahiert wird, welches in dem Festregister SR1 festgehalten wird. In diesem Falle wäre
der in der Zeichnung dargestellte Addierer Add durch
einen Subtrahierer zu ersetzen.

1 Figur
5 Patentansprüche

## Patentansprüche

1. Schaltungsanordnung zum Verstärken bzw. Dämpfen von analogen Eingangssignalen mittels einer Verstärkungs- bzw. Dämpfungsanordnung,
d a d u r c h   g e k e n n z e i c h n e t ,
daß das jeweilige analoge Eingangssignal zunächst in einer analogen Verstärkungs- bzw. Dämpfungsanordnung (AS) in einen bestimmten Pegelbereich gebracht wird, daß das Ausgangssignal der analogen Verstärkungs- bzw. Dämpfungsanordnung (AS) in ein digitales Signal umgesetzt wird,
und daß der Wert des digitalen Signals in festgelegten Stufen verändert wird.

2. Schaltungsanordnung nach Anspruch 1,   d a d u r c h   g e k e n n z e i c h n e t   , daß die analoge Verstärkungs- bzw. Dämpfungsanordnung (AS) eine erste Verstärkungs- bzw. Dämpfungsstufe (Op1, R1, R2, Sw1) enthält, von der das analoge Eingangssignal in seiner Amplitude entweder unverändert oder entsprechend einem Faktor von 2 verändert abgebbar ist.

3. Schaltungsanordnung nach Anspruch 2,   d a d u r c h   g e k e n n z e i c h n e t ,   daß der ersten Verstärkungs- bzw. Dämpfungsstufe (Op1,R1,R2,Sw1) wenigstens eine weitere Verstärkungs- bzw. Dämpfungsstufe (Op2,R3, R4,Sw2) nachgeschaltet ist, von deren jeder das analoge Eingangssignal der jeweils vorangehenden Verstärkungs- bzw. Dämpfungsstufe (z.B. Op1,R1,R2,Sw1) entweder unverändert oder entsprechend einem Faktor $v_x$ verändert abgebbar ist, der der Beziehung
$$v_x = (v_{x-1})^2$$
genügt, wobei $v_{x-1}$ der Verstärkungs- bzw. Dämpfungsgrad der der jeweiligen weiteren Verstärkungs bzw. Dämpfungsstufe (z.B. Op2,R3,R4,Sw2) unmittelbar vorangehenden Verstärkungs- bzw. Dämpfungsstufe (Op1,R1,R2,Sw1) bedeutet.

4. Schaltungsanordnung nach einem der Ansprüche 1 bis 3,
d a d u r c h   g e k e n n z e i c h n e t ,   daß die
Veränderung des Wertes des digitalen Signals mittels
einer Registeranordnung (DS) erfolgt, in der das jeweilige digitale Signal entsprechend einer geforderten
Wertvergrößerung bzw. Wertverkleinerung verschiebbar
ist.

5. Schaltungsanordnung nach Anspruch 4,   d a d u r c h
g e k e n n z e i c h n e t ,   daß die Registeranordnung (DS) ein Festregister (FR1) enthält, in dem das
digitale Signal (X) festgehalten wird und das über eine
Addier- bzw. Subtrahiereinrichtung (Add) mit einem
Schieberegister (SR2) verbunden ist, in welchem das
dort ebenfalls eingeschriebene digitale Signal (X) durch
Verschieben in seinem Wert änderbar ist.

0133991

1/1